Europäisches Patentamt

European Patent Office

Office européen des brevets

(19)

(11) Veröffentlichungsnummer: **0 093 433**
A2

(12) **EUROPÄISCHE PATENTANMELDUNG**

(21) Anmeldenummer: **83104236.1**

(22) Anmeldetag: **29.04.83**

(51) Int. Cl.³: **H 03 L 7/18**
**H 03 L 7/22**

(30) Priorität: **04.05.82 DE 3216531**

(43) Veröffentlichungstag der Anmeldung:
**09.11.83 Patentblatt 83/45**

(84) Benannte Vertragsstaaten:
**BE DE FR GB IT**

(71) Anmelder: **SIEMENS AKTIENGESELLSCHAFT**
**Berlin und München Wittelsbacherplatz 2**
**D-8000 München 2(DE)**

(72) Erfinder: **Fischer, Helmut, Ing.grad.**
**Am Fohlengarten 12d**
**D-8042 Oberschleissheim(DE)**

(54) **Oszillatorschaltung.**

(57) Bei einer Oszillatorschaltung mit einer über eine Phasen-Regelschleife einstellbaren Ausgangsfrequenz ist eine Frequenzteilerschaltung in der Phasen-Regelschleife vorhanden, deren Teilerverhältnis veränderbar ist. Zur Verfeinerung der Einstellmöglichkeiten der Ausgangsfrequenz ($f_a$) ist ein an die Phasen-Regelschleife (PR) angeschalteter Referenz-Oszillator (RO) über einen Zieheingang (6) in seiner Frequenz ($f_{ref}$) geringfügig verziehbar. Das Feinstellsignal ($\Delta f$) am Zieheingang (6) wird unter Berücksichtigung der Einstellung des Teilerverhältnisses (n) der Frequenzteilerschaltung (FT1) gewonnen.

Die Erfindung ist vor allem bei Frequenzsynthesizern anwendbar.

FIG 1

SIEMENS AKTIENGESELLSCHAFT
Berlin und München

Unser Zeichen
VPA 82 P 4420 E

## Oszillatorschaltung

Die Erfindung bezieht sich auf eine Oszillatorschaltung mit einem mittels einer Phasen-Regelschleife auf einer vorgebbaren Frequenz einrastbaren Ausgangsoszillator und einem in der Phasen-Regelschleife befindlichen Phasendiskriminator, der an einem ersten Eingang mit der Frequenz eines Referenz-Oszillators und an einem zweiten Eingang mit dem Ausgang einer auf ein vorgebbares Teilerverhältnis einstellbaren, im Rückkopplungszweig der Phasen-Regelschleife befindlichen Frequenzteilerschaltung verbunden ist, wobei die Frequenz des Referenz-Oszillators innerhalb der Schrittweite der Frequenzteilung mittels einer Feinstellschaltung fein einstellbar ist.

Bei einer bekannten Oszillatorschaltung dieser Art (DE-OS 27 50 150) wird die Frequenz des Referenz-Oszillators mittels einer Schaltungsanordnung, die sich zwischen dem Referenz-Oszillator und dem ersten Frequenzteiler befindet, in bestimmten vorgegebenen Größenordnungen (beispielsweise 100 Hz) verändert. Die Abänderung des Wertes der Referenzfrequenz wird hier z. B. durch die in einem zusätzlichen Speicher festgelegten Werte gesteuert.

Bei einer weiteren bekannten Oszillatorschaltung (Zeitschrift "Frequenz" Nr. 22 (1968), 9, Seiten 255, 256) wird mittels einer Phasen-Regelschleife ein Ausgangssignal mit einer vorgebbaren Frequenz erzeugt. In der Phasen-Regelschleife bei dieser bekannten Oszillatorschaltung ist ein in seiner Frequenz regelbarer Ausgangsoszillator vorhanden, dessen Regelspannung von einem Phasendiskriminator erzeugt wird. Die Regelgröße am Aus-

Ag 4 Bz / 14.03.1983

gang des Phasendiskriminators wird durch Phasenvergleich der durch eine zusätzliche Mischung und Teilung beeinflußten Frequenz des Ausgangsoszillators mit einer Frequenz eines Referenz-Oszillators erzeugt. Der Teilerfaktor bei der Frequenzteilung wird über eine Matrix in fest vorgegebenen Abständen bestimmt, wobei sich an den Eingängen des Phasendiskriminators durch die Rückwirkung innerhalb der Phasen-Regelschleife gleiche Frequenzen einstellen. Abhängig von der Einstellung des Frequenzteilers und somit von der mit dem Phasendiskriminator gewonnenen Regelgröße können somit verschiedene Frequenzen des Ausgangsoszillators eingestellt werden, der das Ausgangssignal der Oszillatorschaltung erzeugt. Die Einstellungen der Frequenz des Ausgangssignals dieser bekannten Oszillatorschaltung werden hierbei mit den ganzzahligen Änderungen des Teilerverhältnisses der Frequenzteilerschaltung vorgenommen; eine noch feinstufigere Veränderung der Frequenz ist nicht möglich.

Der Erfindung liegt die Aufgabe zugrunde, eine Oszillatorschaltung zu schaffen, die bei geringem Schaltungsaufwand eine äußerst feine Einstellung der Frequenz des Ausgangssignals ermöglicht.

Zur Lösung dieser Aufgabe ist bei einer Oszillatorschaltung der eingangs angegebenen Art der Referenz-Oszillator an einem Zieheingang mit dem Ausgang einer Feinstellschaltung verbunden, die an ihren Eingängen mit den das Teilerverhältnis der Frequenzteilerschaltung bestimmenden ersten Stellsignalen beaufschlagt ist, wobei die Feinstellschaltung aus den Stellsignalen ein Feinstellsignal für den Referenz-Oszillator erzeugt, mit dem eine Veränderung der Frequenz des Referenz-Oszillators bewirkbar ist.

Die erfindungsgemäße Oszillatorschaltung hat den Vorteil, daß durch ein in der Regel geringfügiges Verziehen der Ausgangsfrequenz des Referenz-Oszillators eine äußerst feine Veränderung der Ausgangsfrequenz der Oszillatorschaltung vorgenommen werden kann. Das Verziehen der Frequenz des Referenz-Oszillators erfolgt mit einem Feinstellsignal, das aus einer Verknüpfung des für die Feineinstellung bestimmten Stellsignals mit den Stellsignalen für die über die Frequenzteilerschaltung veränderbaren Einstellstufen gewonnen wird. Diese Verknüpfung ist notwendig, da die Änderung der Frequenz des Ausgangssignals durch das Feinstellsignal immer in dem Bereich der mit dem Frequenzteiler eingestellten Stufen bei jeder Frequenz des Ausgangssignals geschehen soll. Hierzu sind somit die Stellsignale für die Frequenzteilerschaltung bei der Erzeugung des Feinstellsignals zu berücksichtigen.

Die Erfindung wird in besonders vorteilhafter Weise mit den in den Unteransprüchen 2 bis 10 beschriebenen Ausführungsformen der erfindungsgemäßen Oszillatorschaltung realisiert. Da die Stellsignale zur Einstellung der Frequenz der Oszillatorschaltung in der Regel codierte Digitalsignale (BCD-Code) sind, kann hierbei die oben erwähnte Verknüpfung der Stellsignale auch mit einer Rechenschaltung vorgenommen werden, die nach einer Digital-Analog-Wandlung das Feinstellsignal für das Verziehen des Referenz-Oszillators zur Verfügung stellt.

Für sich gesehen ist es zwar bereits aus der DE-AS 24 55 236 bekannt, die Ausgangsfrequenz eines Quarzoszillators über die Ansteuerung einer Varactordiode zu verziehen, jedoch wird hier lediglich eine ansonsten mit festgelegter Frequenz schwingende Oszillatoranordnung geringfügig nachgeregelt. Probleme hinsichtlich einer in einem großen Frequenzbereich einrastbaren Oszillatorschaltung und einer Feinverstellung treten hier jedoch nicht auf.

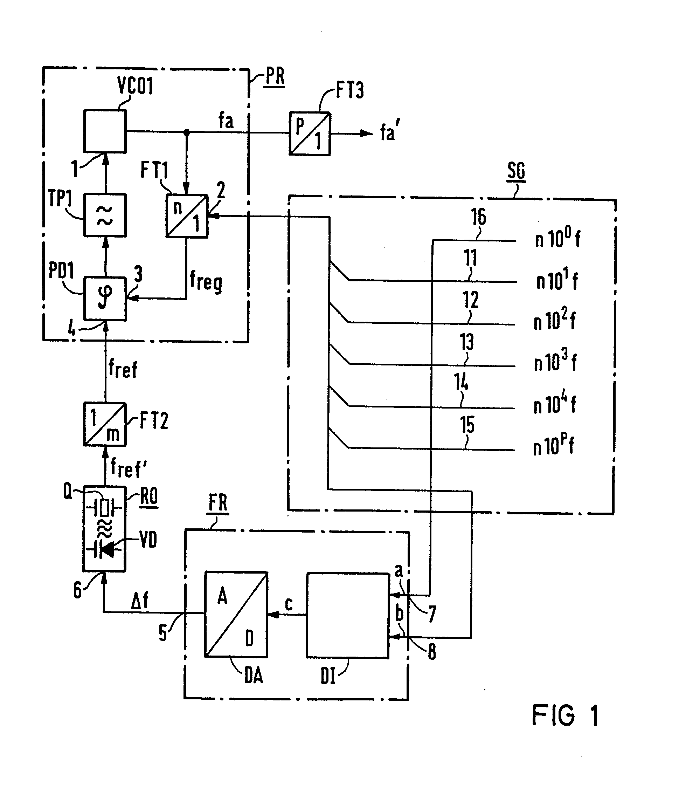

Die Erfindung wird anhand der Figuren erläutert, wobei Figur 1 ein Blockschaltbild der erfindungsgemäßen Oszillatorschaltung,
Figur 2 ein Blockschaltbild einer Schaltungsalternative eines weiteren Ausführungsbeispiels der Oszillatorschaltung,
Figur 3 ein Blockschaltbild einer anderen Schaltungsalternative des weiteren Ausführungsbeispiels und
Figur 4 ein Schaltbild eines Ausführungsbeispiels der Feinstellschaltung der erfindungsgemäßen Oszillatorschaltung darstellt.

Bei dem in der Figur 1 dargestellten Blockschaltbild weist eine Phasen-Regelschleife PR einen Ausgangsoszillator VCO auf, der ein Ausgangssignal mit einer Frequenz $f_a$ erzeugt, die in ihrer Größe über einen Steuereingang 1 regelbar ist. Bei dem Ausgangsoszillator VCO handelt es sich üblicherweise um einen spannungsgesteuerten Oszillator (Voltage Control Oscillator = VCO). Das Ausgangssignal des Ausgangsoszillators ist auf den Eingang einer Frequenzteilerschaltung FT1 geführt, deren

Teilerfaktor n über einen Eingang 2 einstellbar ist. Der Ausgang der Frequenzteilerschaltung FT1 ist auf einen Eingang 3 eines Phasendiskriminators PD1 geführt, an dessen anderem Eingang 4 ein Signal mit einer Referenzfrequenz $f_{ref}$ anliegt. Der Ausgang des Phasendiskriminators PD1 ist über einen Tiefpaß TP1 mit dem Steuereingang 1 des Ausgangsoszillators VCO verbunden.

Zur Erzeugung des Signals mit der Referenzfrequenz $f_{ref}$ ist ein Referenz-Oszillator RO vorhanden, dessen Ausgangsfrequenz $f_{ref}'$ mittels einer nachgeschalteten Frequenzteilerschaltung FT2 mit einem vorgegebenen Teilerfaktor m auf die vorgebbare Frequenz $f_{ref}$ heruntergeteilt wird; das Ausgangssignal der Frequenzteilerschaltung FT2 ist auf den anderen Eingang 4 des Phasendiskriminators PD1 geführt. Der Ausgang 5 einer Feinstellschaltung FR ist mit einem Zieheingang 6 des Referenz-Oszillators RO verbunden. Die Feinstellschaltung FR enthält einen Dividierbaustein DI und einen ihm nachgeschalteten Digital-Analog-Wandler DA. An einem ersten Eingang 7 der Feinstellschaltung FR liegt ein codiertes Signal a und an einem zweiten Eingang 8 liegt ein codiertes Signal b an. Die codierten Signale a und b sind Ausgangssignale eines Stellsignalgebers SG, der über Signalleitungen 11 ... 15 die Stellsignale $n \, 10^1 \, f$ ... $n \, 10^p \, f$ zur Einstellung des gewünschten Teilerverhältnisses des Frequenzteilers FT2 an seinem Eingang 2 abgibt; das codierte Signal b ist das Stellsignal $n \, 10^0 \, f$, das über die Stellsignalleitung 16 auf den Eingang 7 geführt ist, mit ihm wird die kleinstmögliche Verstellung über die Feinstellschaltung FR vorgenommen. Einstellinformationen für eine noch feinere Frequenzeinstellung können in gleicher Weise wie die Stellsignalleitung 16 über weitere Stellsignalleitungen auf den Eingang 7 geführt werden. Die kleinstmögliche Verstellung ist beim dargestellten Ausführungsbeispiel beispielsweise über das Stellsignal $n \, 10^0 \, f$ mit dem Faktor $n \cdot 10 \cdot f_{ref}$

möglich. Das Ausgangssignal des Ausgangsoszillators VCO ist beim dargestellten Ausführungsbeispiel zusätzlich über eine Frequenzteilerschaltung FT3 mit einem vorgebbaren Teilerfaktor q geführt, so daß das Ausgangssignal der Oszillatorschaltung mit der geforderten Ausgangsfrequenz f' am Ausgang der Frequenzteilerschaltung FT3 anliegt.

Die Funktionsweise der erfindungsgemäßen Oszillatorschaltung wird zunächst anhand des Blockschaltbildes nach der Figur 1 erläutert. Die Frequenz $f_a$ des Ausgangssignals des Ausgangsoszillators VCO ergibt sich hier nach der Beziehung:

$$f_a = n \cdot (f_{ref} + \Delta f_{ref}) \tag{1}$$

wobei n der Teilerfaktor des Frequenzteilers FT1 ist und $\Delta f_{ref}$ die über den Zieheingang 6 bewirkbare Verziehung der Frequenz $f_{ref}'$ bzw. $f_{ref}$ des Referenz-Oszillators RO darstellt. Um die Ausgangsfrequenz $f_a$ um eine Schrittweite der Phasen-Regelschleife PR zu verziehen, vorgegeben durch die Stellsignale $n\,10^1\,f \dots n\,10^p\,f$, ist somit eine bestimmte Änderung von $f_{ref}$ nötig, die sich wie folgt errechnet:

$$\frac{f_a + f_{ref}}{f_a} = \frac{n \cdot (f_{ref} + \Delta f_{ref})}{n \cdot f_{ref}} \tag{2}$$

Mit

$$f_a = n \cdot f_{ref} \tag{2'}$$

und

$$f_a + f_{ref} = (n + 1) \cdot f_{ref} \tag{2''}$$

ergibt sich:

$$\frac{n + 1}{n} = 1 + \frac{\Delta f}{f_{ref}} \qquad\qquad (3)$$

Die Gleichung (3) kann auch wie folgt dargestellt werden:

$$\frac{\Delta f_{ref}}{f_{ref}} = \frac{n + 1}{n} - 1 = \frac{1}{n} \qquad\qquad (4)$$

so daß daraus erkennbar ist, daß sich das Verhältnis $\Delta f_{ref}$ zu $f_{ref}$ umgekehrt proportional zum eingestellten Teilerfaktor n verhalten muß, um eine definierte Frequenzänderung der Ausgangsfrequenz $f_a$ zu bewirken. Das Feinstellsignal $\Delta f$ zur Bewirkung der Verziehung der Frequenz $f_{ref}'$ bzw. $f_{ref}$ des Referenz-Oszillators RO muß somit beim dargestellten Ausführungsbeispiel aus der Division der codierten Einstellinformation a (Stellsignal $n\ 10^0\ f$) durch die ebenfalls codierten Einstellinformationen b (Stellsignale $n\ 10^1\ f\ ...\ n\ 10^p\ f$) für die Frequenzteilerschaltung FT1 hergeleitet werden. Das Ausgangssignal des diese Division durchführenden Dividierbausteins DI bildet somit das Signal c ($c = \frac{a}{b}$); dieses Signal c muß anschließend zur Ansteuerung des Referenz-Oszillators RO in ein Analogsignal umgewandelt werden.

Das Verziehen der Frequenz $f_{ref}'$ des Referenz-Oszillators RO mittels des Feinstellsignals $\Delta f$ kann beispielsweise dadurch bewirkt werden, daß der Referenz-Oszillator RO in üblicher Weise als Quarzoszillator mit einem Quarz Q ausgebildet ist, der mittels einer Varactordiode VD in seiner Schwingfrequenz geringfügig verzogen wird. Mit der Frequenzteilerschaltung FT2 wird die Ausgangsfrequenz $f_{ref}'$ des Referenz-Oszillators RO um einen vorgegebenen Teilerfaktor m auf die gewünschte Referenzfrequenz $f_{ref}$ heruntergeteilt. Die Bausteine des Phasen-Regelkreises PR sind so dimensioniert, daß, wenn beispielsweise die Frequenz $f_{ref}$ = 2 kHz ist, auch die Frequenz $f_{req}$ am Ausgang der Frequenzteilerschaltung FT1 2 kHz beträgt. Diese Einstellung der Frequenz wird durch eine Dimensionierung des Ausgangsoszillators VCO und durch eine entsprechend angepaßte Einstellinformation am Eingang 2 der Frequenzteilerschaltung FT1 erreicht. Die Nachführung der Frequenz des Ausgangsoszillators VCO wird über den Phasenvergleich des Phasendiskriminators PD1 vorgenommen.

Die Schrittweite bei der Frequenzeinstellung der Ausgangsfrequenz $f_a$ des Ausgangsoszillators VCO der erfindungsgemäßen Oszillatorschaltung ist im dargestellten Fall 2 kHz; durch eine weitere Frequenzteilung dieser Ausgangsfrequenz in der Frequenzteilerschaltung FT3 kann beispielsweise bei einem entsprechend vorgegebenen Teilerfaktor q die Schrittweite auf 10 Hz ($f_a'$) heruntergesetzt werden. Zwischen diesen 10 Hz-Schritten können nun z. B. 1 Hz-Schritte durch Verziehen des Referenz-Oszillators RO über die Feinstellschaltung FR eingefügt werden. Auch eine weitere Verkleinerung der Schrittweite bei der Frequenzeinstellung ist möglich, wobei die Grenzen hier durch die Güte des Referenz-Oszillators RO vorgegeben sind.

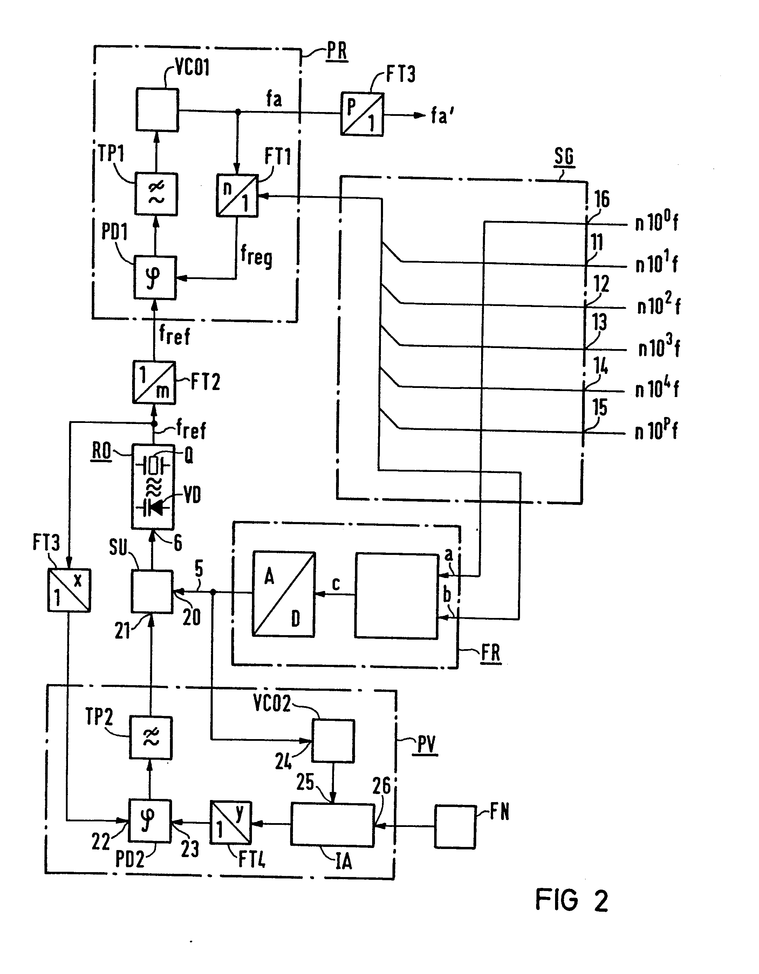

Das in der Figur 2 dargestellte Ausführungsbeispiel der Oszillatorschaltung weist aufbauend auf das Blockschaltbild nach der Figur 1 eine zusätzliche Anordnung eines Frequenznormals FN zur Erhöhung der Frequenzgenauigkeit des Referenz-Oszillators RO in Verbindung mit einer Phasen-Vergleichsschaltung PV auf. Die bei diesem Ausführungsbeispiel mit dem Blockschaltbild nach der Figur 1 identischen Bausteine sind mit gleichen Bezugszeichen versehen. Der Ausgang 5 der Feinstellschaltung FR ist beim Ausführungsbeispiel nach der Figur 2 auf einen Eingang 20 einer Summenschaltung SU geführt, an deren anderem Eingang 21 der Ausgang der Phasen-Vergleichsschaltung PV angeschlossen ist. Der Ausgang der Summenschaltung SU ist mit dem Zieheingang 6 des Referenz-Oszillators RO verbunden. Der Ausgang des Referenz-Oszillators RO ist über eine Frequenzteilerschaltung FT3 mit dem vorgegebenen Teilerfaktor x auf einen Eingang 22 eines Phasendiskriminators PD2 geführt; ein anderer Eingang 23 des Phasendiskriminators PD2 ist mit dem Ausgang einer Frequenzteilerschaltung FT4 mit dem vorgegebenen Teilerfaktor y verbunden. Der Ausgang des Phasendiskriminators PD2 ist mit dem Eingang des Tiefpasses TP2 verbunden, dessen Ausgang den Ausgang der Phasen-Vergleichsschaltung darstellt.

Der Ausgang 5 der Feinstellschaltung FR ist mit dem Steuereingang eines in seiner Frequenz steuerbaren Oszillators VCO2 verbunden, dessen Ausgangssignal auf den Eingang 25 einer Impulsaddierstufe IA geführt ist. Ein anderer Eingang 26 der Impulsaddierstufe IA ist mit dem Ausgangssignal des Frequenznormals FN beaufschlagt. Das Ausgangssignal der Impulsaddierstufe IA ist über die Frequenzteilerschaltung FT4 auf den anderen Eingang 23 des Phasendiskriminators PD2 geführt.

Bei dem Ausführungsbeispiel nach der Figur 2 wird erreicht, daß mit dem Regeloszillator VCO2 eine vom Feinstellsignal $\Delta f$ gesteuerte Frequenz erzeugt wird, die zur Frequenzstabilisierung über die Impulsaddierstufe IA mit der Ausgangsfrequenz des Frequenznormals FN beaufschlagt wird und somit mittels des Phasendiskriminators PD2 ein Vergleich dieser zusätzlich erzeugten Frequenz mit der Ausgangsfrequenz des Referenz-Oszillators RO möglich ist. Die Anzahl der zu addierenden Impulse in der Impulsaddierstufe IA pro Sekunde ergibt sich aus dem Verhältnis der Frequenz des Frequenznormals FN von beispielsweise 10 MHz zur gesteuerten Ausgangsfrequenz des Regeloszillators VCO2 und somit auch zur Größe des Feinstellsignals $\Delta f$. Für die angenommene Frequenz des Frequenznormals von 10 MHz und einer gewünschten Ausgangsfrequenz von 1,000009 MHz - entsprechend der maxi-

malen Verziehbarkeit des Referenz-Oszillators RO - ergibt sich eine Ausgangsfrequenz des Regeloszillators
VCO2 von

$$f_{VCO2} = \frac{10 \text{ MHz}}{1,000009 \text{ MHz}} \cdot 9 \text{ Hz} \quad f_{VCO2} \approx 90 \text{ Hz} \quad (5)$$

Die Zeitkonstante des Tiefpasses TP2 wird so groß bemessen, daß die addierten Impulse nach der Impulsaddierstufe IA keinen störenden Phasenjitter des Ausgangssignals der Summenschaltung SU verursachen. Diese Zeitkonstante kann groß sein, da über die Zusatzanordnung
nach der Figur 2 im wesentlichen nur Langzeitänderungen
der Frequenz des Referenz-Oszillators ausgeglichen werden (Temperaturdrift, Alterung etc.). Die Teilerfaktoren x, y der Frequenzteilerschaltungen FT3 und FT4 sind
entsprechend der Frequenz des Frequenznormals FN zu wählen, so daß sich an den Eingängen 22 und 23 des Phasendiskriminators PD2 die geforderten Frequenzen einstellen.

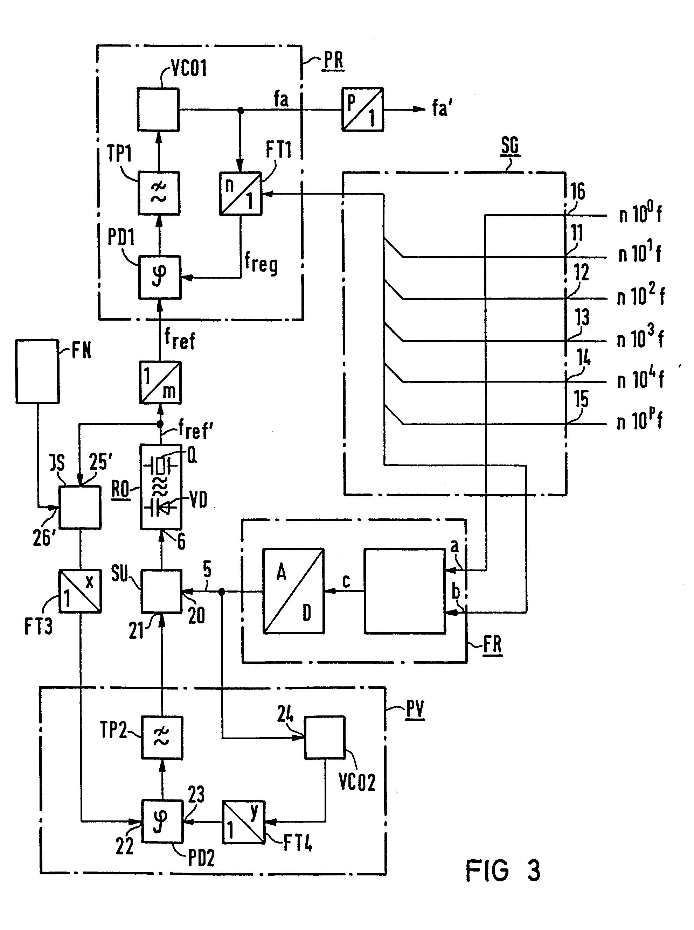

Das in der Figur 3 gezeigte, zu der Ausführung nach Figur 2 alternative Ausführungsbeispiel enthält eine Impulssubtrahierstufe IS, an deren einen Eingang 25' der
Ausgang des Referenz-Oszillators RO geführt ist und an
deren anderem Eingang 26' das Ausgangssignal des Frequenznormals FN anliegt. Die Ausgänge der Impulssubtrahierstufe IS und des Regeloszillators VCO2 sind - wie
bei der Ausführung nach der Figur 2 - über Frequenzteilerschaltungen FT3 und FT4 auf die Eingänge 22 und 23
des Phasendiskriminators PD2 geführt. Die Funktion der
Oszillatorschaltung nach diesem Ausführungsbeispiel ist
mit der Funktion des Ausführungsbeispiels nach der Figur 2 bis auf die abweichende Anordnung des Frequenznormals FN und den dadurch bedingten Einsatz einer Impulssubtrahierstufe IS anstelle einer Impulsaddierstufe
identisch.

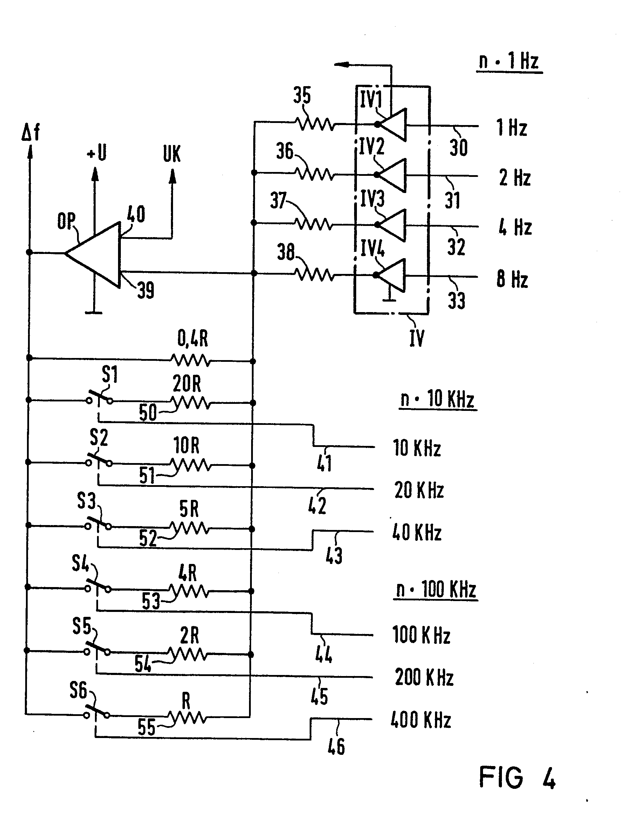

Der in der Figur 4 dargestellte Schaltungsplan zeigt den Aufbau eines Ausführungsbeispiels der Feinstellschaltung FR zur Erzeugung des Feinstellsignals $\Delta f$. Die Eingabe von Stellsignalen $n\,10^0\,f$ zur Feinrasteinstellung der Ausgangsfrequenz zur Oszillatorschaltung erfolgt hier über Eingänge 30 ... 33 beispielsweise für die Frequenzen mit der Schrittweite 1 Hz. Das im BCD-Code codierte Stellsignal $n\,10^0\,f$ liegt parallel an den vier Eingängen 30 ... 33 an und wird in der aus CMOS-Invertern IV1 ... IV4 aufgebauten Inverterschaltung IV und entsprechend bemessenen Bewertungswiderständen 35 ... 38 in ein entsprechendes analoges Signal umgewandelt. Dieses analoge Signal liegt an einem Eingang 39 eines Operationsverstärkers OP an. Der andere Eingang 40 des Operationsverstärkers OP ist mit einer konstanten Spannung UK beaufschlagt. Die Stellsignale $n\,10^1\,f$ ... $n\,10^p\,f$ für die höherstufigen Verstellinformationen, beispielsweise $n \cdot 10$ kHz bzw. $n \cdot 100$ kHz, liegen an Eingängen 41 ... 46 an. Diese Stellsignale und andere, noch weitere höherstufige Verstellinformationen betreffende Stellsignale liegen ebenfalls - hier nicht dargestellt - als Einstellinformationen am Stelleingang 2 der Frequenzteilerschaltung FT1 - vergleiche Figur 1 - an. Die Umwandlung dieser Stellsignale in ein analoges Signal erfolgt hier durch Einschalten von Bewertungswiderständen 50 ... 55 mit den Beträgen 20 R ... R - mit R als Bezugswert - über Schalter S1 ... S6 in den Rückkopplungszweig des Operationsverstärkers OP. Parallel zu den Widerständen 50 ... 55 und den Schaltern S1 ... S6 ist ein Widerstand 56 mit der Größe $0{,}4 \cdot R$ geschaltet, der zur Berücksichtigung der Offsetfrequenz der Oszillatorschaltung bei einer digitalen Frequenzeingabe von O dient. Durch die hier dargestellte Beschaltung des Operationsverstärkers OP wird gleichzeitig eine Digital-Analog-Wandlung aller Stellsignale und eine Division der Stellsignale - wie anhand der Figur 1 beschrieben - vorgenommen. Eine hinreichend große Genauigkeit bei der Division ist gewährleistet, wenn – wie hier dargestellt – beispielsweise nur die Stellsignale für n · 20 kHz, n · 40 kHz, n · 80 kHz und n · 100 kHz, n · 200 kHz und n · 400 kHz für die Division herangezogen werden. Zur Anpassung an jeweils andere Schaltungsbedingungen sind jedoch auch andere Kombinationen möglich.

10 Patentansprüche
4 Figuren

Patentansprüche

1. Oszillatorschaltung mit

a) einem mittels einer Phasen-Regelschleife auf einer vorgebbaren Frequenz einrastbaren Ausgangsoszillator und

b) einem in der Phasen-Regelschleife befindlichen Phasendiskriminator, der
   b1) an einem ersten Eingang mit der Frequenz eines Referenz-Oszillators und
   b2) an einem zweiten Eingang mit dem Ausgang einer auf ein vorgebbares Teilerverhältnis einstellbaren, im Rückkopplungszweig der Phasen-Regelschleife befindlichen Frequenzteilerschaltung verbunden ist, wobei die Frequenz des Referenz-Oszillators innerhalb der Schrittweite der Frequenzteilung mittels einer Feinstellschaltung fein einstellbar ist,

dadurch gekennzeichnet , daß

c) der Referenz-Oszillator (RO) an einem Zieheingang (6) mit dem Ausgang einer Feinstellschaltung (FR) verbunden ist, die
   c1) an ihren Eingängen mit den das Teilerverhältnis der Frequenzteilerschaltung (FT1) bestimmenden ersten Stellsignalen ($n\,10^1\,f\,\ldots\,n\,10^p\,f$) beaufschlagt ist, wobei
   c2) die Feinstellschaltung (FR) aus den Stellsignalen (nF) ein Feinstellsignal ($\Delta F$) für den Referenz-Oszillator (RO) erzeugt, mit dem eine Veränderung der Frequenz ($f_{ref}$) des Referenz-Oszillators (RO) bewirkbar ist.

2. Oszillatorschaltung nach Anspruch 1, dadurch gekennzeichnet , daß d) die Feinstellschaltung (FR) so ausgebildet ist, daß die maximale Änderung des Feinstellsignals ($\Delta F$) wiederum zu einer solchen Frequenzänderung des Referenz-Oszillators (RO) führt, die über die Phasen-Regelschleife eine Änderung der Ausgangsfrequenz ($f_a$) der Oszillatorschaltung innerhalb der mit den Stellsignalen (nF) eingestellten Schrittweite bewirkt.

3. Oszillatorschaltung nach einem der vorhergehenden Ansprüche, d a d u r c h   g e k e n n z e i c h n e t , daß

e) die Feinstellschaltung (FR) einen Dividierbaustein (DI) enthält, an

e1) dessen einem Eingang (a) mindestens ein zweites codiertes Stellsignal ($n\,10^0\,f$) anliegt, das eine geringere Änderung der Ausgangsfrequenz ($f_a$) bewirkt, als mit den Stellsignalen ($n\,10^1\,f \ldots n\,10^p\,f$) über die Frequenzteilerschaltung (FT1) bewirkbar ist, an

e2) dessen weiterem Eingang die ersten codierten Stellsignale ($n\,10^1\,f \ldots n\,10^p\,f$) anliegen, mit denen eine Änderung der Ausgangsfrequenz ($f_a$) über eine Änderung des Teilerverhältnisses der Frequenzteilerschaltung (FT1) bewirkbar ist, und der

e3) an seinem Ausgang ein digitales Ausgangssignal (c) aufweist, das der Division des zweiten durch das erste Stellsignal entspricht, und daß

f) das binäre Ausgangssignal (c) des Dividierbausteins (DI) über einen Digital-Analog-Wandler (DA) auf den Ausgang der Feinstellschaltung (FR) geführt ist.

4. Oszillatorschaltung nach einem der vorhergehenden Ansprüche, d a d u r c h   g e k e n n z e i c h n e t , daß

g) das Feinstellsignal (ΔF) als Ausgangssignal der Feinstellschaltung (FR) auf einen Eingang (20) einer Summenschaltung (SU) geführt ist, auf dessen anderen Eingang (21) der Ausgang einer von einem Frequenznormal (FN) angesteuerten Phasen-Vergleichsschaltung (PV) geschaltet ist, wobei

g1) der Ausgang der Summenschaltung auf den Zieheingang (6) des Referenz-Oszillators (RO) geführt ist.

5. Oszillatorschaltung nach Anspruch 4, d a d u r c h g e k e n n z e i c h n e t , daß

h) ein Regel-Oszillator (VCO2) als Bestandteil der Phasen-Vergleichsschaltung (PV) mit dem Feinstellsignal (ΔF) beaufschlagt ist,

i) der Ausgang des Regel-Oszillators (VCO2) mit einem Eingang (25) einer Impulsaddierstufe (IA) verbunden ist, deren anderer Eingang (26) mit dem Ausgangssignal des Frequenznormals (FN) beaufschlagt ist, daß

j) der Ausgang der Impulsaddierstufe (IA) mit dem einen Eingang (23) eines zweiten Phasendiskriminators (PD2) verbunden ist, dessen anderer Eingang (22) mit dem Ausgangssignal des Referenz-Oszillators (RO) beaufschlagt ist, und daß

k) der Ausgang des zweiten Phasendiskriminators (PD2) über einen Tiefpaß (TP2) auf den Ausgang der Phasen-Vergleichsstufe (PV) und somit auf den anderen Eingang (21) der Summenschaltung (SU) geführt ist.

6. Oszillatorschaltung nach Anspruch 4, d a d u r c h g e k e n n z e i c h n e t , daß

l) ein Regel-Oszillator (VCO2) als Bestandteil der Phasen-Vergleichsschaltung (PV) mit dem Feinstellsignal ($\Delta$F) beaufschlagt ist,

m) der Ausgang des Regel-Oszillators (VCO2) mit dem einen Eingang (23) eines zweiten Phasendiskriminators (PD2) verbunden ist, dessen anderer Eingang mit dem Ausgangssignal einer Impulssubtrahierstufe (IS) verbunden ist, die

m1) an einem Eingang (25') mit dem Ausgangssignal des Referenz-Oszillators (RO) und an einem anderen Eingang (26') mit dem Ausgangssignal des Frequenznormals (FN) beaufschlagt ist, und daß

n) der Ausgang des zweiten Phasendiskriminators (PD2) über einen Tiefpaß (TP2) auf den Ausgang der Phasen-Vergleichsstufe (PV) und somit auf den anderen Eingang (21) der Summenschaltung (SU) geführt ist.

7. Oszillatorschaltung nach Anspruch 5 oder 6, d a - d u r c h   g e k e n n z e i c h n e t ,   daß

o) vor jeden der Eingänge des zweiten Phasendiskriminators (PD2) jeweils eine Frequenzteilerschaltung (FT3, FT4) mit vorgebbarem Teilerverhältnis geschaltet ist.

8. Oszillatorschaltung nach einem der Ansprüche 3 bis 7, d a d u r c h   g e k e n n z e i c h n e t ,   daß

p) der Dividierbaustein (DI) und der Digital-Analog-Wandler (DA) durch einen rückgekoppelten Operationsverstärker (OP) gebildet sind,

p1) an dessen einem Differenzeingang (39) die jeweils über einen Bewertungswiderstand (35 ... 38) geführten Ausgänge von Inverterbausteinen (IV1 ... IV4) anliegen, wobei an den Eingängen (30 ... 33) der Inverterschaltung (IV) das zweite codierte

Stellsignal ($n\ 10^0\ f$) für die Frequenzeinstellung der Oszillatorschaltung anliegt, die nicht über eine Änderung des Teilerverhältnisses der Frequenzteilerschaltung (FT1) bewirkt wird,

p2) an dessen anderem Differenzeingang eine konstante Spannung anliegt,

p3) in dessen Rückkopplungszweig weitere Bewertungswiderstände zur Berücksichtigung der ersten Stellsignale ($n\ 10^1\ f\ \dots\ n\ 10^p\ f$) liegen, wobei die Bewertungswiderstände jeweils über ein von den ersten Stellsignalen angesteuertes Schaltelement (S1 ... S6) einschaltbar sind und

p4) dessen Ausgang den Ausgang (5) der Feinstellschaltung (FR) darstellt.

9. Oszillatorschaltung nach Anspruch 7, d a d u r c h g e k e n n z e i c h n e t , daß

q) die Inverterbausteine (IV1 ... IV4) aus CMOS-Invertern gebildet sind.

10. Oszillatorschaltung nach einem der vorhergehenden Ansprüche, d a d u r c h g e k e n n z e i c h n e t , daß

r) der Referenz-Oszillator aus einem Quarzoszillator aufgebaut ist, dessen Quarz (Q) mit einer Varactordiode (VD) derart zusammengeschaltet ist, daß mittels des Feinstellsignals ($\Delta F$) ein Verziehen der Frequenz ($f_{ref}$) am Ausgang des Referenz-Oszillators (RO) erzielbar ist.

FIG 1

FIG 2

FIG 3

FIG 4